(19) Europäisches Patentamt
European Patent Office
Office européen des brevets

(11) Publication number: 0 489 983 A1

(12) # EUROPEAN PATENT APPLICATION

(21) Application number: 90203340.6

(51) Int. Cl.5: G03F 7/06, G03F 7/07

(22) Date of filing: 14.12.90

(43) Date of publication of application:
17.06.92 Bulletin 92/25

(84) Designated Contracting States:
AT BE CH DE DK ES FR GB GR IT LI LU NL SE

(71) Applicant: AGFA-GEVAERT naamloze vennootschap
Septestraat 27
B-2640 Mortsel(BE)

(72) Inventor: Leenders, Luc Herwig
Lichtaartseweg 182
B-2200 Herentals(BE)
Inventor: Van Cleuvenbergen, Rudy Jozef
Collegelaan 83 B14
B-2140 Borgerhout(BE)
Inventor: Schuerwegen, Ronald
Paepevelden 26
B-2627 Schelle(BE)
Inventor: Monbaliu, Marcel Jacob
Neuris 9
B-2640 Mortsel(BE)

(54) **A lithographic printing plate.**

(57) According to the present invention a method is provided for producing a lithographic printing plate comprising the steps of:

- image-wise exposing an imaging element comprising a silver halide emulsion layer,
- developing said imaging element in the presence of compound that releases a hydrophobizing agent upon reaction with either the reduced or oxidized form of a developing agent,
- allowing said hydrophobizing agent to react with an oleophobic metal layer comprised in said imaging element or comprised in a separate receiving element to render said metal layer image-wise oleophilic.

The present invention further provides an imaging element and receiving element for use in the above described method.

EP 0 489 983 A1

1. Field of the invention.

The present invention relates to an imaging element for producing a lithographic printing plate and a method for producing a lithographic printing plate.

2. Background of the invention.

Lithography is the process of printing from specially prepared surfaces, some areas of which are capable of accepting lithographic ink, whereas other areas, when moistened with water, will not accept the ink. The areas which accept ink form the printing image areas and the ink-rejecting areas form the background areas.

In the art of photolithography, a photographic material is made image-wise receptive to oily or greasy inks in the photo-exposed (negative-working) or in the non-exposed areas (positive-working) on a hydrophilic background.

Negative type lithographic printing plates are preferred in 'Computer to plate' application. In these applications, Ar-lasers, He/Ne lasers, semi-conductor lasers and LED's are modulated by the digital information, corresponding to the image to be written on the plate, from an output device. Employing a negative type lithographic printing plate in these applications can thus save time since only the image-portions of the original, which make up only a small percentage of the original, have to be written on the plate.

Common photographic materials employed for obtaining a lithographic printing plate are materials based on a photosensitive polymer or silver salt diffusion transfer materials.

Silver salt diffusion transfer materials offer the advantage of high speed in a broad spectral range while common photosensitive polymers are only sensitive to light of a narrow spectral range, commonly between 300nm and 500nm. Furthermore photosensitive polymers do not offer the speed of a silver halide material.

Both of these photographic materials can in principle be used to produce a negative type lithographic printing plate. However, todate only negative type lithographic printing plates based on a photosensitive polymer are commonly employed.

Because of the advantages of a silver halide material mentioned above, several attempts have been made to use the silver salt diffusion transfer method for obtaining a negative type lithographic printing plate.

A negative type lithographic printing plate using the silver salt diffusion transfer process can be obtained by using a direct positive type emulsion instead of the usual negative working emulsions. Such a method is described in e.g. Japanese Patent Laid-open application (Kokai) No. 96648/01, CA-P-1139767 and US-P-4309499. This method has however the disadvantage that relative large amounts of silver are required and furthermore the speed of such a material is rather low.

Another method for obtaining a negative type lithographic printing plate based on the silver salt diffusion transfer process is described in US-P-4693955. Said US patent describes a silver halide diffusion transfer material comprising on a support in the order given, a layer containing a light-sensitive silver halide, a layer containing non-light-sensitive metal salt particles and a layer containing physical development nuclei. The layer containing the light-sensitive silver halide also contains a substance that releases a compound, which acts either as a solubiliser for the above mentioned non-photosensitive metal salt particles or as a solubilising physical developing promoter, upon reaction with the oxidized developing agent. After image-wise exposure and during the development said compound image-wise releases the solubiliser or solubilising physical developing promoter for the metal salt particles which then image-wise solubilises the metal salt particles and deposits them in the layer containing the development nuclei where a negative image is thus obtained that can be used for printing with a lithographic ink.

However such a method has the disadvantage that relative high amounts of the compound that releases the solubiliser or solubilising physical developing promoter have to be used to obtain an image of sufficient density. Furthermore, this compound is difficult to prepare thus increasing the cost of the imaging element.

As is apparent from the above description, several attempts have been made to produce a negative type lithographic printing plate based on a silver halide material, however without satisfactory results.

It is thus an object of the present invention to provide an imaging element based on silver halide for producing a negative type as well as a positive type lithographic printing plate.

It is a further object of the present invention to provide a method for producing a lithographic printing plate based on a silver halide material.

Still further objects of the present invention will become clear from the description hereinafter.

3. Summary of the invention.

According to the present invention a method is provided for producing a lithographic printing plate comprising the steps of:

- image-wise exposing an imaging element comprising a silver halide emulsion layer,
- developing said imaging element in the presence a compound that upon reaction with either the reduced or oxidized form of a developing agent releases a hydrophobizing agent,
- allowing said hydrophobizing agent to react with an oleophobic metal layer comprised in said imaging element or comprised in a separate receiving element to render said layer image-wise oleophilic.

According to the present invention an element is provided comprising on a support (i) a metal layer and (ii) a layer comprising a compound capable of releasing a hydrophobizing agent for said metal layer upon reaction with either the reduced or oxidized form of a silver halide developing agent.

The present invention also provides an element comprising on a support (i) a metal layer, (ii) a compound capable of releasing a hydrophobizing agent for said metal layer upon reaction with either the reduced or oxidized form of a silver halide developing agent and (iii) a silver halide emulsion layer.

3. Detailed description of the invention.

Suitable compounds that release a hydrophobizing agent upon reaction with either the reduced or oxidized form of a developing agent for use in accordance with the present invention are compounds wherein the hydrophobizing agent is linked to a carrier moiety. Several mechanisms are known in the prior art for releasing a compound from a carrier moiety. Releasing mechanisms of the hydrophobizing agent that can be used in accordance with the present invention are disclosed in the article of C. Van de Sande in Angew. Chem. Int. Ed. Engl. 22 (1983) pages 191-209 which is hereby included by reference. Preferred mechanisms for releasing of the hydrophobizing agent from the carrier moiety are the so-called redox controlled systems in which the hydrophobizing agent can only be released from the carrier moiety upon alkaline hydrolizes when the carrier moiety is either in its reduced or oxidized form.

According to the most preferred mode of the present invention the hydrophobizing agent is released from the carrier moiety upon a coupling reaction with the oxidized form of a developing agent. Such carrier moieties are known as couplers and the corresponding compounds are known as coupler compounds.

Coupler compounds are well known compounds used in color photographic recording materials to produce a dye since upon coupling with an oxidized developing agent with the coupler compound a dye can be formed. See for example EP-A-347849, US patents 3148062, 3227554, 3617291 and 3660095. Coupler compounds are also known which upon reaction with an oxidized developing agent produce a colorless compound. Examples of such compounds are disclosed in e.g. GB-P-861138 and US patents 3632345, 3928041, 3958993 and 3961959.

In addition to the formation of a dye or a colorless compound upon reaction of the coupler compounds with an oxidized developing agent the coupler compounds may also release a photographical useful group (PUG). Examples of PUG's that can be released from a coupler compound are development inhibiting compounds as disclosed in e.g. EP 347849, fogging agents as disclosed in US-P-4390618, and development accelerating compounds disclosed in e.g. US-P-3253924 and EP 347849.

Hydrophobizing agents are frequently used in the art of lithography for increasing the hydrophobicity of e.g. a silver image obtained by the silver salt diffusion transfer method. Hydrophobizing agents often contain a mercapto group capable of reacting with a metal layer. US-P-3,776,728 describes the use of heterocyclic mercapto-compounds, e.g. a 2-mercapto-1,3,4-oxadiazole derivative, as hydrophobizing agents. US-P-4,563,410 discloses hydrophobizing liquids containing one or more mercaptotriazole or mercaptotetrazole derivatives.

Preferred coupler compounds that release a hydrophobizing agent upon a coupling reaction with the oxidized form of a developing agent for use in accordance with the present invention correspond to the general formula:

COUP-MERCAPTO (I)

wherein COUP represents a coupler moiety and MERCAPTO represents a moiety that after release from COUP contains a mercapto group and that is attached to the coupling position of the coupler moiety.

Examples of coupler moieties suitable for use in accordance with the present invention are those coupler moieties described in EP347849 and in the references made therein and which are hereby included by reference. Preferred couplers for use in accordance with the present invention are couplers that form magenta dyes upon coupling e.g. pyrazolones or pyrazolotriazoles, yellow-dye forming couplers e.g. acylacetamides e.g. benzoylacetanilides or pivalylacetanilides, cyan-dye forming couplers e.g. phenols or

naphthols, couplers forming a colorless product upon coupling e.g. cyclic carbonyl containing compounds etc.

MERCAPTO moieties suitable for use in accordance with the present invention are heterocyclic moieties corresponding to general formula (II):

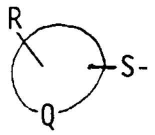 (II)

wherein R represents hydrogen, an alkyl group, an alkylaryl group, an alkoxy group, an aryl group or substituted aryl group, Q represents a group of atoms necessary to complete a heterocyclic ring including fused heterocyclic ring systems e.g. oxazole, oxadiazole, triazole, tetrazole, thiazole, thiadiazole, imidazole, benzimidazole, benzoxazole, benzthiazole, etc..

A preferably used MERCAPTO moiety is:

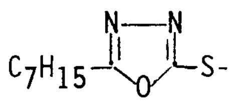

Suitable metal layers for use in accordance with the present invention are continuous metal layers that are capable of reacting with the above described mercapto compounds e.g. bismuth or silver. A preferred metal layer is a layer of metallic silver. The metal layer can be applied by vapor deposition or vacuum deposition.

Another method for applying the metal layer and particularly suitable for applying a metallic silver layer to a support comprises the deposition of metal salt complexes to a support in the presence of physical development nuclei and developing agents according to the silver salt diffusion transfer process. The principles of the silver salt diffusion transfer process are described in more detail in e.g. US-P-2352014 and the book "Photographic Silver Halide Diffusion Processes" by André Rott and Edith Weyde - The Focal Press -London and New York, (1972).

According to a first embodiment of the present invention a coupler compound corresponding to general formula I is comprised in an imaging element comprising on a support (i) a layer of metallic silver and (ii) a silver halide emulsion layer.

The imaging element is image-wise exposed and subsequently developed. During the developing step the coupler compound will react with the oxidized form of a developing agent and as a consequence a compound comprising a mercapto group is image-wise released. The compound containing a mercapto group will image-wise diffuse to the layer of metallic silver to react with the metallic silver layer and to image-wise render the metallic silver layer oleophilic. The silver halide emulsion is subsequently removed e.g. by rinsing with water and a lithographic printing plate is thus obtained.

The imaging element of the present invention may also comprise a layer containing at least 70 % of a non-proteinic hydrophilic film-forming polymer between the layer of metallic silver and the silver halide emulsion layer to facilate the removal of the silver halide emulsion layer after development. Appropriate non-proteinic hydrophilic film-forming polymers for use with the present invention have to be chosen from the group of film-forming polymers that are soluble in aqueous medium and thus soften and swell by adsorption of water. Suitable polymers are e.g. polyvinyl alcohol, polyvinyl pyrrolidone, polyethylene oxide, partly hydrolyzed polyvinyl acetate, sulphonated polystyrene, hydroxyethyl cellulose, carboxymethyl cellulose, cellulose acetate hydrogen phthalate, dextran, dextrins or derivatives thereof, starch, gum arabic, and alginic acid derivatives e.g. salts or esters thereof. It is also possible to use mixtures of two or more different non-proteinic hydrophilic film-forming polymers. Preference is given, however, to at least one polyvinyl alcohol having a molecular weight not higher than 15,000. The ratio of alcohol and acetate units in the polyvinyl alcohol does not seem to play an important role.

Instead of the layer of a non-proteinic hydrophilic film forming polymer, a layer containing latex particles or a mixture of latex particles and a non-proteinic hydrophilic film forming polymer may be used. Suitable latex particles for use with the present invention are polymer particles of homopolymers or copolymers of vinyl monomers e.g. styrene, (meth)acrylate, vinyl acetate, vinyl chloride, vinylidene chloride etc.

The coupler compound comprised in the imaging element may be present in the silver halide emulsion

layer and/or in a layer in water permeable relationship therewith for example the above described layer between the layer of metallic silver and the silver halide emulsion layer.

In a second embodiment of the present invention an imaging element is provided comprising on a support a silver halide emulsion layer and a coupler compound. After image-wise exposure the imaging element is developed in contact with a receiving element comprising on a support a layer of metallic silver. Both elements are separated after a short developing time. A lithographic printing plate is thus obtained.

On top of the layers of the imaging element there may be provided a layer of a non-proteinic hydrophilic film-forming polymer or a layer of latex particles as described above. The coupler compound may be present in one or more layers comprised in the imaging element.

A third embodiment of the present invention provides a receiving element comprising on a support a layer of metallic silver and a layer of the coupler compound. After image-wise exposure of an imaging element comprising on a support at least a silver halide emulsion layer, the imaging element is developed in contact with the receiving element. After a short developing time the elements are separated and the receiving sheet is preferably rinsed with water. A lithographic printing plate is thus obtained.

The receiving element may also comprise a layer of a non-proteinic hydrophilic film-forming polymer or a layer of latex particles or a mixture thereof, as described above, separating the metal layer comprised on the support of the receiving element from any other subsequent layer.

It may be advantageous to improve the differentiation between the oleophilic and oleophobic parts of the lithographic printing plate obtained according to one of the above described embodiments. The obtained printing plate may thus be treated with a bleaching liquid to remove metallic silver in the areas of the lithographic printing plate where no or insufficient reaction of the metal layer with the mercapto compound has occurred, to further improve the differentiation between the image and non-image parts, the complexation with the mercapto group leading to a good etch-resistance. The bleaching liquid comprises a silver bleaching agent e.g. ferric salts and complexes, iodine, hydroxyperoxide, quinone etc.. A ferric complex is preferably used. A subsequent treatment of the plate with a solution containing hydrophobizing agents may still furhter improve the differentiation between the oleophilic and oleophobic parts. US-P-3,776,728 describes the use of heterocyclic mercapto-compounds, e.g. a 2-mercapto-1,3,4-oxadiazole derivative, as hydrophobizing agents. US-P-4,563,410 discloses hydrophobizing liquids containing one or more mercaptotriazole or mercaptotetrazole derivatives.

The developing liquid used in accordance with the present invention may comprise any of the silver halide developing agents used in the releasing mechanisms referred to hereinbefore. For use with the preferred coupler compounds a color developing agent is used e.g. para-phenylene-diamine derivatives or para-aminophenol derivatives. The developing liquid has a pH between 10 and 14. As alkaline substances sodium hydroxide, sodium or potassium carbonate and/or primary, secundary or tertiary alkanol amines or mixtures thereof may be used as disclosed in the unpublished European patent application no. 90201224.4, EP-397926, EP-397925, EP-397927, US-P-4632896 and DE-OS-3533449. The developing liquid may also comprise additional developing agents e.g. developing agents of the 1-phenyl-3-pyrazolidone type. Alternatively the developing agent(s) and/or additional developing agents may be comprised in one or more layers comprised in the imaging element and/or receiving element. In the latter case the developing liquid is merely an alkaline activating liquid.

The silver halide emulsion layer comprised on the imaging element of the present invention may be any type of silver halide emulsion layer. The halide composition of the silver halide emulsion used according to the present invention is not specifically limited and may be any composition selected from i.a. silver chloride, silver bromide, silver iodide, silver chlorobromide, silver bromoiodide, and silver chlorobromoiodide. The content of silver iodide is equal to or less than 20 mol%, preferably equal to or less than 5 mol%, even more preferably equal to or less than 3 mol%.

The photographic silver halide emulsion used according to the present invention can be prepared by mixing the halide and silver solutions in partially or fully controlled conditions of temperature, concentrations, sequence of addition, and rates of addition. The silver halide can be precipitated according to the single-jet method, the double-jet method, or the conversion method.

The silver halide particles of the photographic emulsion used according to the present invention may have a regular crystalline form e.g. a cubic or octahedral form or they may have a transition form. They may also have an irregular crystalline form e.g. a spherical form or a tabular form, or may otherwise have a composite crystal form comprising a mixture of said regular and irregular crystalline forms.

The silver halide grains may have a multilayered grain structure. According to a simple embodiment the grains may comprise a core and a shell, which may have different halide compositions and/or may have undergone different modifications e.g. the addition of dopes. Besides having a differently composed core and shell the silver halide grains may also comprise different phases inbetween.

Two or more types of silver halide emulsion that have been prepared differently can be mixed for forming a photographic emulsion for use in accordance with the present invention.

The size distribution of the silver halide particles of the photographic emulsions to be used according to the present invention can be homodisperse or heterodisperse. A homodisperse size distribution is obtained when 95% of the grains have a size that does not deviate more than 30% from the average grain size.

The silver halide crystals can be doped with $Rh^{3+}$, $Ir^{4+}$, $Cd^{2+}$, $Zn^{2+}$, $Pb^{2+}$.

The photographic emulsion can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966).

The emulsion can be desalted in the usual ways e.g. by dialysis, by flocculation and re-dispersing, or by ultrafiltration. Apart from negative-working silver halide emulsions that are preferred for their high photosensitivity, use can be made also of direct-positive silver halide emulsions that produce a positive silver image in the emulsion layer.

For instance, direct-positive emulsions of the type described in US-A 3,062,651 may be employed. In direct-positive emulsions a non-hardening fogging agent e.g. stannous chloride and formamidine sulphinic acid can be used.

Besides the silver halide another essential component of a light-sensitive emulsion layer is the binder. The binder is a hydrophilic colloid, preferably gelatin. Gelatin can, however, be replaced in part or integrally by synthetic, semi-synthetic, or natural polymers. Synthetic substitutes for gelatin are e.g. polyvinyl alcohol, poly-N-vinyl pyrrolidone, polyvinyl imidazole, polyvinyl pyrazole, polyacrylamide, polyacrylic acid, and derivatives thereof, in particular copolymers thereof. Natural substitutes for gelatin are e.g. other proteins e.g. zein, albumin and casein, cellulose, saccharides, starch, and alginates. In general, the semi-synthetic substitutes for gelatin are modified natural products e.g. gelatin derivatives obtained by conversion of gelatin with alkylating or acylating agents or by grafting of polymerizable monomers on gelatin, and cellulose derivatives e.g. hydroxyalkyl cellulose, carboxymethyl cellulose, phthaloyl cellulose, and cellulose sulphates.

The gelatin can be lime-treated or acid-treated gelatin. The preparation of such gelatin types has been described in e.g. "The Science and Technology of Gelatin", edited by A.G. Ward and A. Courts, Academic Press 1977, page 295 and next pages. The gelatin can also be an enzyme-treated gelatin as described in Bull. Soc. Sci. Phot. Japan, N° 16, page 30 (1966).

The light-sensitive silver halide emulsion can be a so-called primitive emulsion, in other words an emulsion that has not been chemically sensitized. However, the light-sensitive silver halide emulsion is preferably chemically sensitized as described i.a. in the above-mentioned "Chimie et Physique Photographique" by P. Glafkides, in the above-mentioned "Photographic Emulsion Chemistry" by G.F. Duffin, in the above-mentioned "Making and Coating Photographic Emulsion" by V.L. Zelikman et al, and in "Die Grundlagen der Photographischen Prozesse mit Silberhalogeniden" edited by H. Frieser and published by Akademische Verlagsgesellschaft (1968). As described in said literature chemical sensitization can be carried out by effecting the ripening in the presence of small amounts of compounds containing sulphur e.g. thiosulphate, thiocyanate, thioureas, sulphites, mercapto compounds, and rhodamines. The emulsions can be sensitized also by means of gold-sulphur ripeners or by means of reductors e.g. tin compounds as described in GB-A 789,823, amines, hydrazine derivatives, formamidine-sulphinic acids, and silane compounds. Chemical sensitization can also be performed with small amounts of Ir, Rh, Ru, Pb, Cd, Hg, Tl, Pd, Pt, or Au. One of these chemical sensitization methods or a combination thereof can be used.

The light-sensitive silver halide emulsions can be spectrally sensitized with methine dyes e.g. those described by F.M. Hamer in "The Cyanine Dyes and Related Compounds", 1964, John Wiley & Sons. Dyes that can be used for the purpose of spectral sensitization include cyanine dyes, merocyanine dyes, complex cyanine dyes, complex merocyanine dyes, holopolar cyanine dyes, hemicyanine dyes, styryl dyes and hemioxonol dyes. Particularly valuable dyes are those belonging to the cyanine dyes, merocyanine dyes, complex merocyanine dyes.

Other dyes, which per se do not have any spectral sensitization activity, or certain other compounds, which do not substantially absorb visible radiation, can have a supersensitization effect when they are incorporated together with said spectral sensitizing agents into the emulsion. Suitable supersensitizers are i.a. heterocyclic mercapto compounds containing at least one electronegative substituent as described e.g. in US-A 3,457,078, nitrogen-containing heterocyclic ring-substituted aminostilbene compounds as described e.g. in US-A 2,933,390 and US-A 3,635,721, aromatic organic acid/formaldehyde condensation products as described e.g. in US-A 3,743,510, cadmium salts, and azaindene compounds.

The silver halide emulsion for use in accordance with the present invention may comprise compounds

preventing the formation of fog or stabilizing the photographic characteristics during the production or storage of photographic elements or during the photographic treatment thereof. Many known compounds can be added as fog-inhibiting agent or stabilizer to the silver halide emulsion. Suitable examples are i.a. the heterocyclic nitrogen-containing compounds e.g. benzothiazolium salts, nitroimidazoles, nitrobenzimidazoles, chlorobenzimidazoles, bromobenzimidazoles, mercaptothiazoles, mercaptobenzothiazoles, mercaptobenzimidazoles, mercaptothiadiazoles, aminotriazoles, benzotriazoles (preferably 5-methyl-benzotriazole), nitrobenzotriazoles, mercaptotetrazoles, in particular 1-phenyl-5-mercapto-tetrazole, mercaptopyrimidines, mercaptotriazines, benzothiazoline-2-thione, oxazoline-thione, triazaindenes, tetrazaindenes and pentazaindenes, especially those described by Birr in Z. Wiss. Phot. 47 (1952), pages 2-58, triazolopyrimidines e.g. those described in GB-A 1,203,757, GB-A 1,209,146, JA-Appl. 75-39537, and GB-A 1,500,278, and 7-hydroxy-s-triazolo-[1,5-a]-pyrimidines as described in US-A 4,727,017, and other compounds e.g. benzenethiosulphonic acid, benzenethiosulphinic acid, benzenethiosulphonic acid amide. Other compounds that can be used as fog-inhibiting compounds are metal salts e.g. mercury or cadmium salts and the compounds described in Research Disclosure N° 17643 (1978), Chaptre VI.

The fog-inhibiting agents or stabilizers can be added to the silver halide emulsion prior to, during, or after the ripening thereof and mixtures of two or more of these compounds can be used.

The imaging element of the present invention may further comprise various kinds of surface-active agents in the photographic emulsion layer or in at least one other hydrophilic colloid layer. Suitable surface-active agents include non-ionic agents e.g. saponins, alkylene oxides e.g. polyethylene glycol, polyethylene glycol/polypropylene glycol condensation products, polyethylene glycol alkyl ethers or polyethylene glycol alkylaryl ethers, polyethylene glycol esters, polyethylene glycol sorbitan esters, polyalkylene glycol alkylamines or alkylamides, silicone-polyethylene oxide adducts, glycidol derivatives, fatty acid esters of polyhydric alcohols and alkyl esters of saccharides; anionic agents comprising an acid group e.g. a carboxy, sulpho, phospho, sulphuric or phosphoric ester group; ampholytic agents e.g. aminoacids, aminoalkyl sulphonic acids, aminoalkyl sulphates or phosphates, alkyl betaines, and amine-N-oxides; and cationic agents e.g. alkylamine salts, aliphatic, aromatic, or heterocyclic quaternary ammonium salts, aliphatic or heterocyclic ring-containing phosphonium or sulphonium salts. Such surface-active agents can be used for various purposes e.g. as coating aids, as compounds preventing electric charges, as compounds improving slidability, as compounds facilitating dispersive emulsification, as compounds preventing or reducing adhesion, and as compounds improving the photographic characteristics e.g. higher contrast, sensitization, and development acceleration.

Development acceleration can be accomplished with the aid of various compounds, preferably polyalkylene derivatives having a molecular weight of at least 400 e.g. those described in e.g. US-A 3,038,805 - 4,038,075 - 4,292,400.

The imaging element of the present invention may further comprise various other additives e.g. compounds improving the dimensional stability of the photographic element, UV-absorbers, spacing agents, hardeners, and plasticizers.

Suitable additives for improving the dimensional stability of the photographic element are i.a. dispersions of a water-soluble or hardly soluble synthetic polymer e.g. polymers of alkyl (meth)acrylates, alkoxy-(meth)acrylates, glycidyl (meth)acrylates, (meth)acrylamides, vinyl esters, acrylonitriles, olefins , and styrenes, or copolymers of the above with acrylic acids, methacrylic acids, Alpha-Beta-unsaturated dicarboxylic acids, hydroxyalkyl (meth)acrylates, sulphoalkyl (meth)acrylates, and styrene sulphonic acids.

Suitable UV-absorbers are i.a. aryl-substituted benzotriazole compounds as described in US-A 3,533,794, 4-thiazolidone compounds as described in US-A 3,314,794 and 3,352,681, benzophenone compounds as described in JP-A 2784/71, cinnamic ester compounds as described in US-A 3,705,805 and 3,707,375, butadiene compounds as described in US-A 4,045,229, and benzoxazole compounds as described in US-A 3,700,455.

The supports of the imaging element or receiving element suitable for use in accordance with the present invention may be any support commonly used in the lithographic printing art. Examples of supports suitable for use in accordance with the present invention are metallic supports e.g. zinc or aluminium, paper supports, polyester film supports which may be coated with a hydrophilic layer as disclosed in e.g. US-P-3971660, a paper support or polyethylene support which may be coated with the hydrophilic layer, a metallized polyester film, etc. An aluminium support is preferably used for the imaging element according to the first embodiment referred herein before and for the receiving elements of the other embodiments. When used with a receiving element the imaging element preferably has a non-metallic support of the kind referred to.

Suitable aluminium supports for use in accordance with the present invention are aluminium foils made of pure aluminium or of an aluminium alloy, the aluminium content of which is at least 95%. A useful alloy is

e.g. one comprising 99.55% by weight of Al, 0.29% of Fe, 0.10% of Si, 0.004% of Cu, 0.002% of Mn, 0.02% of Ti, and 0.03% of Zn. The thickness of the foil usually ranges from about 0.13 to about 0.50 mm.

The preparation of aluminium or aluminium alloy foils for lithographic offset printing comprises the following steps : graining, anodizing, and optionally sealing of the foil.

Graining and anodization of the foil are necessary to obtain a lithographic printing plate that allows to produce high-quality prints in accordance with the present invention. Sealing is not necessary but may still improves the printing results.

Graining of the aluminium surface can be carried out mechanically or electrolytically in any known way. The roughness produced by the graining is measured as a centre line average value expressed in $\mu$m and preferably varies from about 0.2 to about 1.5 $\mu$m.

The anodization of the aluminium foil can be performed in electrolytes e.g. chromic acid, oxalic acid, sodium carbonate, sodium hydroxide, and mixtures thereof. Preferably, the anodization of the aluminium is performed in dilute aqueous sulphuric acid medium until the desired thickness of the anodization layer is reached. The aluminium foil may be anodized on both sides. The thickness of the anodization layer is most accurately measured by making a micrographic cut but can be determined likewise by dissolving the anodized layer and weighing the plate before dissolution treatment and subsequent thereto. Good results are obtained with an anodization layer thickness of about 0.4 to about 2.0 $\mu$m. To promote the image sharpness and, as a consequence thereof, the sharpness of the final printed copy, the anodization layer may be coloured in the mass with an antihalation dye or pigment e.g. as described in JA-A 58-14797. The dye or pigment or a combination of dyes or pigments used for such colouring in the mass are chosen such that they prevent or reduce halation in silver halide emulsions having any desired photosensitivity range comprised between 300 and 900 nm.

After the anodizing step the anodic surface may be sealed. Sealing of the pores of the aluminium oxide layer formed by anodization is a technique known to those skilled in the art of aluminium anodization. This technique has been described in e.g. the "Belgisch-Nederlands tijdschrift voor Oppervlaktetechnieken van materialen", 24ste jaargang/januari 1980, under the title "Sealing-kwaliteit en sealing-controle van geanodiseerd Aluminium". Different types of sealing of the porous anodized aluminium surface exist. An advantageous sealing method is the hydration-sealing method, according to which the pores are closed or partially closed through water-acceptance so that hydrated needle-like aluminium oxide crystals (böhmite) are formed. The anodic surface of the aluminium foil can thus be rinsed with water at 70-100 °C or with steam. The hot sealing water may comprise additives e.g. nickel salts to improve the sealing effect. The sealing can also be performed by treatment of the anodic surface with an aqueous solution comprising phosphate ions or silicates. Thanks to the sealing treatment the anodic layer is rendered substantially non-porous so that longer press runs can be made with the printing plate obtained. As a result of the sealing the occurrence of fog in the non-printing areas of the printing plate is avoided substantially.

The graining, anodizing, and sealing of the aluminium foil can be performed as described in e.g. US-A 3,861,917 and in the documents referred to therein.

The imaging element described in the first embodiment of the present invention can be made by providing a hydrophilic grained and anodized surface of an aluminium foil with a metallic layer of silver using a method as described above and coating thereon a water-swellable intermediate layer comprising for at least 70% of its total weight at least one non-proteinic hydrophilic film-forming polymer or an intermediate layer containing latex particles, and coating the intermediate layer with at least one silver halide emulsion layer. The coupler compound corresponding to general formula I may be present in the silver halide emulsion layer and/or in a layer in water permeable relationship therewith for example the above described intermediate layer.

According to another method the preferably used imaging element of the present invention can be prepared by the following steps :

- coating a temporary base with at least one silver halide emulsion layer,
- coating said at least one silver halide emulsion layer with a water-swellable intermediate layer comprising for at least 70% of its total weight at least one non-proteinic hydrophilic film-forming polymer or an intermediate layer containing latex particles, and
- pressing the thus formed photosensitive layer packet with its side carrying said water-swellable intermediate layer against the metallic silver surface contained on an aluminium support, which has been wetted with an aqueous moistening liquid, the temporary base being removed before or after photo-exposure.

The present invention is illustrated by the following examples without limiting it thereto. All parts are by weight unless otherwise specified.

EXAMPLE 1

An aluminium foil having a thickness of 0.15 mm was grained, anodized, and sealed according to the method described in Example 1 of US-A 3,861,917. The centre line average value obtained by the graining was 0.5 µm. The anodization layer having a weight of 2.7 g per $m^2$ was coated with a silver-receptive stratum from a silver sol in water comprising no binder, prepared according to the Carey Lea method, the resulting stratum having a weight in dried condition of 4 mg of silver per $m^2$. The thus prepared aluminium support was provided with a metallic silver layer by developing a non-exposed diffusion transfer negative in a diffusion transfer developer in contact with the aluminium support and subsequently separating the negative from the aluminium support. A receiving element of aluminium comprising a silver layer in an amount of 0.3g/$m^2$ is thus obtained.

On a polyethyleneterephthalate film support (coated with a hydrophilic adhesion layer) was coated a silver chlorobromoiodide emulsion containing 0.75 mol % of iodide and 1.35 mol % of bromide in an amount of silver halide corresponding to 2.46g/$m^2$ of $AgNO_3$. Three elements obtained in this way were each coated with an aqueous 5% gelatin dispersion containing 2% of one of the coupler compounds shown in table 1 at a dry thickness of 5µm. The imaging elements thus obtained, each comprised a different coupler compound.

Table 1

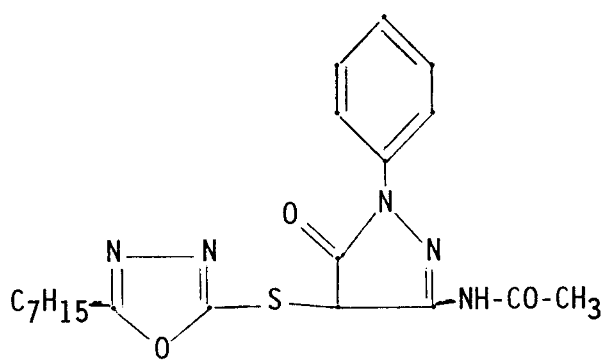

1

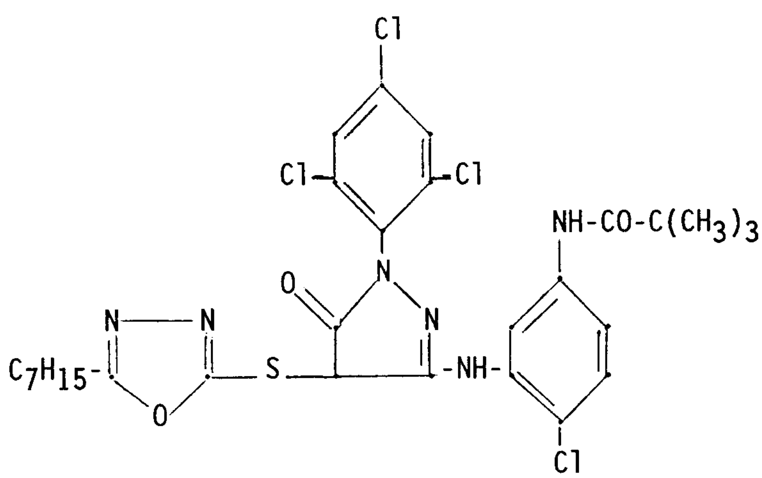

2

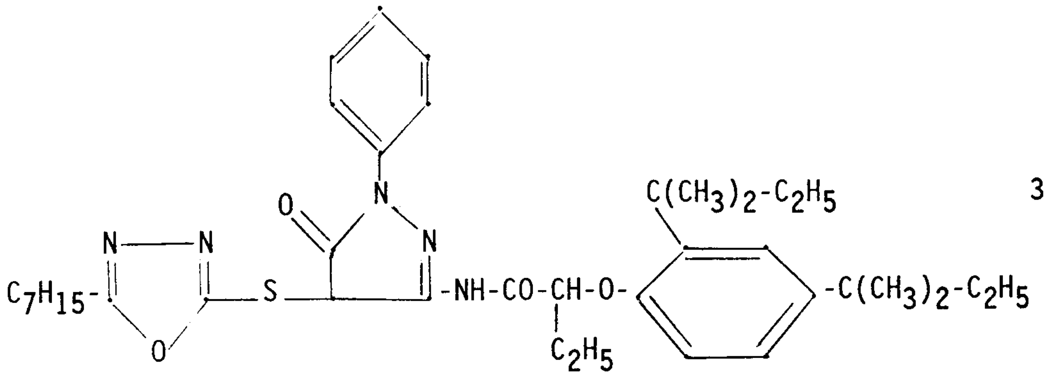

3

A fourth imaging element was prepared in an analogous way but instead of the gelatin coupler dispersion an aqueous 5% polyvinylalcohol dispersion containing 2% of coupler compound number 3 of table 1 was coated at a dry thickness of 5µm.

The imaging elements were each image-wise exposed and subsequently developed in contact with a receiving element as described in a developing solution of the following composition.

| | |
|---|---|
| $K_2CO_3$ | 20 g/l |
| $Na_2SO_3$ | 1 g/l |
| N-hydroxyethyl-N-ethyl-paraphenylene diamine sulphate | 8 g/l |
| NaOH | to obtain a pH of 10.7 |

After 2 min. the imaging element and receiving element were separated for each of the four samples and the receiving element was rinsed with water of 50 ° C for about 15s. Part of the thus obtained receiving element was bleached in a bleaching liquid with the following composition for about 10s to 30s and subsequently rinsed with water.

| Composition of the bleaching liquid | |
|---|---|
| Sodium salt of Ethylene Diamine Tetracetate (EDTA) | 8.4g/l |
| EDTA.$NH_4$Fe | 91g/l |
| $(NH_4)_2S_2O_3$ | 50g/l |
| $K_2SO_3$ | 13.1g/l |
| Acetic acid (96% solution) | 25ml/l |

Four different printing plates were thus obtained which each were mounted on an offset press running with a commonly employed ink and fountain solution. Good copies could be obtained with each of the four printing plates.

EXAMPLE 2

Three imaging elements were prepared by coating a silver chlorobromoiodide emulsion containing 0.75 mol % of iodide and 1.35 mol % of bromide on a polyethyleneterephthalate film support (coated with a hydrophilic adhesion layer) in an amount of silver corresponding to 2.46g/$m^2$ of $AgNO_3$.

Each of these imaging elements was image-wise exposed and subsequently developed in contact with each of the first three receiving elements prepared as described in example 1 in a developer of the composition described in example 1. After 2 min. the imaging element and receiving element were separated for each of the three samples and the receiving elements were rinsed with water of 50 ° C for about 15s. The thus obtained receiving elements were bleached in a bleaching liquid with a composition as described in example 1 for 10s to 30s and subsequently rinsed. Three different printing plates were thus obtained that each were mounted on an offset press running with a commonly employed ink and fountain solution. Good copies could be obtained with each of the three printing plates.

EXAMPLE 3

Two elements were prepared as follows. On an unsubbed cellulose triacetate film support serving as a temporary support was coated a silver chlorobromoiodide emulsion containing 0.75 mol % of iodide and 1.35 mol % of bromide in an amount of silver corresponding to 2.46 g/$m^2$ of $AgNO_3$.

To a first of such an element was coated an aqueous 5% gelatin dispersion containing 2 % of coupler compound 3 of table 1 at a dry thickness of 5$\mu$m and subsequently thereto an aqueous 2% polyvinyl alcohol solution at a dry thickness of 0.7$\mu$m.

To a second element was coated an aqueous dispersion containing 2% of coupler compound 3 of table 1 and 5% of polyvinylalcohol to a dry thickness of 5$\mu$m.

Each of these 2 elements were laminated to an aluminium support comprising a metallic silver layer, prepared as described in example 1. The metallic silver surface on the aluminium support was moistened with water before the lamination. The temporary support was subsequently peeled off and each of the resulting elements were allowed to dry. Two imaging elements were thus obtained.

The imaging elements were image-wise exposed and subsequently developed in a developer of the composition described in example 1. The thus obtained image-wise exposed imaging elements were rinsed with water at room temperature and subsequently bleached in a bleaching liquid with a composition as described in example 1. After rinsing two different printing plates were obtained which each were mounted on an offset press running with a commonly employed ink and fountain solution. Good copies could be obtained with each of the two printing plates.

EXAMPLE 4

To an unsubbed cellulose triacetate film support serving as a temporary support was coated a silver chlorobromo iodide emulsion containing 0.75 mol % of iodide and 1.35 mol % of bromide in an amount of silver corresponding to 2.46 g/$m^2$ of $AgNO_3$. The silver halide emulsion layer further contained 0.59g/$m^2$ of coupler compound 3 shown in table 1. The emulsion layer was overcoated with an aqueous 0.9% polyvinyl alcohol solution at a dry thickness of 0.3 $\mu$m.

The thus obtained element was laminated to an aluminium support comprising a metallic silver layer, prepared as described in example 1. The metallic silver surface on the aluminium support was moistened with water before the lamination. The temporary support was subsequently peeled off and the resulting element was allowed to dry. An imaging element was thus obtained.

The imaging element was image-wise exposed and subsequently developed in a developer of the composition described in example 1. The thus obtained image-wise exposed imaging element was rinsed with water at room temperature and subsequently bleached in a bleaching liquid with a composition as described in example 1. After rinsing a printing plate was obtained which was mounted on an offset press running with a commonly employed ink and fountain solution. Several good copies could be printed.

EXAMPLE 5

To an unsubbed cellulose triacetate film support serving as a temporary support was coated a silver chlorobromo iodide emulsion containing 0.75 mol % of iodide and 1.35 mol % of bromide in an amount of silver corresponding to 2.46 g/$m^2$ of $AgNO_3$. An aqueous 5% gelatin dispersion, containing 2% of coupler compound 3 of table 1, was subsequently coated at a dry thickness of 5$\mu$m. Then an aqueous solution containing 3.8% of a polymethyl methacrylate latex and 0.3% of a latex of a copolymer of methyl methacrylate, methacrylic acid and stearyl methacrylate was applied at a dry thickness of 1.5 $\mu$m.

The thus obtained element was laminated to an aluminium support comprising a metallic silver layer, prepared as described in example 1. The metallic silver surface on the aluminium support was moistened with water before the lamination. The temporary support was subsequently peeled off and the resulting element was allowed to dry. An imaging element was thus obtained.

The imaging element was image-wise exposed and subsequently developed in a developer of the composition described in example 1. The thus obtained image-wise exposed imaging element was rinsed with water at room temperature and subsequently bleached in a bleaching liquid with a composition as described in example 1. After rinsing a printing plate was obtained which was mounted on an offset press running with a commonly employed ink and fountain solution. Several good copies could be printed.

**Claims**

1. A method for producing a lithographic printing plate comprising the steps of:
   - image-wise exposing an imaging element comprising a silver halide emulsion layer,
   - developing said imaging element in the presence of a compound that upon reaction with either the oxidized or reduced form of a developing agent image-wise releases a hydrophobizing compound
   - allowing said hydrophobizing agent to react with an oleophobic metal layer comprised in said imaging element or comprised in a separate receiving element to render said metal layer image-wise oleophilic.

2. A method according to claim 1 wherein said imaging element comprises on a support, (i) said metal layer, (ii) said silver halide emulsion layer and (iii) said compound that releases a hydrophobizing agent upon reaction with either the reduced or oxidized form of a developing agent.

3. A method according to claim 1 wherein said imaging element comprises on a support said silver halide emulsion layer and said imaging element is developed in the presence of said compound that release a hydrophobizing agent upon reaction with either the reduced or oxidized form of a developing agent while in contact with a receiving element comprising on a support said metal layer.

4. A method according to claim 3 wherein said compound that releases a hydrophobizing agent upon reaction with either the reduced or oxidized form of a developing agent is comprised in one of the layers comprised on the support of said imaging element and/or in a separate layer in said receiving element.

5. A method according to any of the above claims wherein said compound that releases said hydrophobizing agent is a coupler compound that upon coupling releases said hydrophobizing agent and wherein said hydrophobizing agent contains a mercapto group after said release.

6. A method according to any of the above claims wherein said metal layer is a metallic silver layer.

7. An element comprising on a support (i) a metal layer and (ii) a layer comprising a compound capable of releasing a hydrophobizing agent for said metal layer upon reaction with either the reduced or oxidized form of a silver halide developing agent.

8. An element according to claim 7 further comprising a silver halide emulsion layer.

9. An element according to claim 7 or 8 wherein said metal layer is a metallic silver layer.

10. An element according to any of claims 7 to 9 wherein said compound capable of releasing a hydrophobizing agent for said metal layer upon reaction with either the reduced or oxidized form of a silver halide developing agent is a coupler compound that releases said hydrophobizing agent upon coupling with the oxidized form of a developing agent and wherein said hydrophobizing agent is a compound that contains a mercapto group upon said release.

11. An element according to claim 10 wherein said hydrophobizing agent corresponds to the general formula:

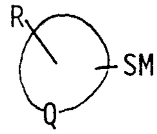

wherein R represents hydrogen, an alkyl group, an alkylaryl group, an alkoxy group, an aryl group or a substituted aryl group, Q represents a group of atoms necessary to complete a heterocyclic ring including fused heterocyclic ring systems and M represents hydrogen or a metal cation.

12. An element according to claim 11 wherein said hydrophobizing agent corresponds to the formula:

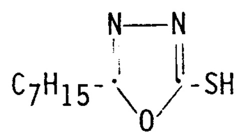

**13.** An element according to any of claims 7 to 12 wherein a layer of a non-proteinic hydrophilic film forming polymer and/or latex particles is directly adhered to said metal layer comprised in said element. 14. An element according to claim 13 wherein said non-proteinic hydrophilic film forming polymer is polyvinyl alcohol. 15. An element according to claim 13 wherein said latex particles are particles of a homopolymer or copolymer of a (meth)acrylate monomer.

European Patent Office

# EUROPEAN SEARCH REPORT

Application Number

EP 90 20 3340

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | DE-A-1597762 (FUJI SHASHIN FILM)<br>* page 3, line 20 - page 4, line 19; claims *<br>--- | | G03F7/06<br>G03F7/07 |
| D,A | EP-A-87176 (AGFA-GEVAERT)<br>----- | | |

TECHNICAL FIELDS SEARCHED (Int. Cl.5)

G03F

The present search report has been drawn up for all claims

| Place of search | Date of completion of the search | Examiner |
|---|---|---|
| THE HAGUE | 05 AUGUST 1991 | PHILOSOPH L. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)